# EUROPÄISCHE PATENTSCHRIFT

(11) **EP 0 528 240 B1**
(45) Veröffentlichungstag und Bekanntmachung des Hinweises auf die Patenterteilung: **09.11.1994**
(21) Anmeldenummer: 92113154.6
(22) Anmeldetag: 01.08.1992
(51) Int. Cl.: H05K 9/00

(54) **Geräteschrank**
Equipment cabinet
Panneau d'appareillage

(30) Priorität: 20.08.1991 DE 4127468
(43) Veröffentlichungstag der Anmeldung: 24.02.1993
(73) Patentinhaber: Schroff GmbH, D-75334 Straubenhardt (DE); SIEMENS AKTIENGESELLSCHAFT, 80333 München (DE)
(72) Erfinder: Schwenk, Hans Martin, Ing.(grad.), W-7541 Straubenhardt 2 (DE); Pohl, Kurt, Dipl. - Ing. (FH), W-8000 München 83 (DE); Hüller, Gerhard, Dipl. -Ing. (FH), W-8175 Reichersbeuern (DE)
(74) Vertreter: Durm, Klaus, Dr.-Ing.

(56) Entgegenhaltungen:
- EP-A- 0 255 587
- EP-A- 0 306 694
- EP-A- 0 340 773
- EP-A- 0 427 550
- DE-A- 2 134 815
- DE-A- 2 829 255
- DE-C- 3 611 693

## Beschreibung

Die Erfindung betrifft einen Geräteschrank für elektronische und elektrische Einschubgeräte mit einem selbsttragenden Gestell zur Halterung der Einschubgeräte sowie mit metallenen Verkleidungsteilen, umfassend Seitenwände, Rückwand, Tür, Dach und Boden, siehe beispielsweise EP-A- 0 427 550.

An Geräteschränke zur Aufnahme von Elektronik-Baugruppen werden eine Reihe von Anforderungen gestellt. So müssen diese eine ausgezeichnete mechanische Festigkeit - auch gegenüber Vibrationsbelastungen und bei Erdbeben - aufweisen. Die zudem verlangte gute Zugänglichkeit zu den Einschüben erfordert leicht entfernbare Verkleidungsteile, die nicht nur Schutz gegen Staub und Wasser, sondern auch gegen elektromagnetische Einstrahlungen bieten.

Um eine optimale hochfrequenzmäßige Abschirmung zu erzielen, ist bisher versucht worden, mit Hilfe der Verkleidung eine möglichst lückenlos geschlossene, elektrisch leitfähige Hülle um den Geräteschrank zu bilden. Dies geschah durch Herstellung einer Vielzahl von leitfähigen Verbindungen zwischen den verschiedenen Verkleidungsteilen und dem Gestell sowie den Gestellteilen selbst und den Verkleidungsteilen untereinander. Dieses Vorgehen erfordert sorgfältige, aufwendige Handarbeit beim Aufbau des Geräteschrankes und insbesondere ein sehr gut elektrisch leitfähiges, tragendes Gestell, was durch galvanische Oberflächenveredelung, zum Beispiel mit Nickel, oder durch Einsatz von nicht rostendem Stahl erreicht werden kann. Auch ist es nicht möglich, Gestelle, die für einfache Anwendungen auf preiswerte Weise ohne Rücksicht auf Abschirmmaßnahmen gefertigt werden, wahlweise oder nachträglich mit einer HF-Abschirmung zu versehen.

Eine andere Lösung des Abschirmproblems ist das Einsetzen des Gestells in einen allseits geschlossenen, verlöteten oder verschweißten Kasten, auf welchem eine mit Kontakten versehene Tür aufliegt; nachteilig hierbei ist jedoch die schlechte Zugänglichkeit zu den Einschüben, welche nur durch die geöffnete Tür möglich ist.

Es ist eine Dichtung für einen Geräteschrank bekannt, welcher ein Rahmengestell aufweist, an dem Verkleidungsteile, nämlich Wände, Tür, Dach und Boden befestigt sind. Das Rahmengestell ist aus Metallprofilen zusammengesetzt, welche nach außen weisende Flansche bzw. Leisten aufweisen, auf die Dichtungsleisten aufgeklemmt sind. Diese Dichtungsleisten bestehen aus Gummi und tragen zu ihrer Befestigung eine im Profil U-förmige, mit Widerhaken versehene federelastische Einlage. Die Dichtungsleiste ist von außen mit einem leitfähigen Metallgeflecht überzogen, welches das Rahmengestell mit den angeschraubten Verkleidungsteilen elektrisch verbindet. EP-OS 0 427 550.

Des weiteren ist ein Schaltschrank mit einem Rahmengestell bekannt, welches ringsum eine Verkleidung mit einer Tür aufweist. Zur HF-Abschirmung dient ein kastenförmiger, in das Rahmengestell eingeschobener, allseits geschlossener Einsatz, und in die Innenseite der Tür ist eine Abschirmplatte eingesetzt. Zum Zwecke der Abdichtung sind sowohl die Kanten des Einsatzes wie diejenigen der Abschirmplatte mit aufsteckbaren, federnden Kontaktstreifen versehen, die in Schließstellung der Tür miteinander in Deckung kommen. (DE-PS 36 11 693).

Abdichtstreifen zum Abdichten und Abschirmen von Schlitzen und Fugen von abzuschirmenden Geräten, welche aus einer Kordel aus Metallgeflecht und einem anvulkanisierten Gummi-Abdichtprofil bestehen, sind durch die DE-OS 28 29 255 bekanntgeworden.

Die Aufgabe der Erfindung besteht in der Konzeption eines Geräteschranks mit einem selbsttragenden Gestell für elektronische und elektrische Einschubgeräte, welche die hohen Kosten für die HF-Abschirmung reduziert und es ermöglicht, das gleiche Gestell sowohl für einen ungeschirmten wie einen geschirmten Schrank zu verwenden.

Zur Lösung der gestellten Aufgabe wird von einem Geräteschrank mit einem selbsttragenden Gestell zur Halterung der Geräteeinschübe sowie mit metallenen Verkleidungsteilen, umfassend Seitenwände, Rückwand, Tür, Dach und Boden ausgegangen. Die Lösung besteht darin, daß zwecks Abschirmung gegenüber elektromagnetischen Wellen die Verkleidungsteile entlang ihrer Ränder miteinander korrespondierende, elektrisch gut leitende Kontaktflächen aufweisen, zwischen denen federelastische, aus elektrisch gut leitfähigem Material bestehende Kontaktstreifen angeordnet sind.

Die vorgeschlagene Ausbildung der Randbereiche der Verkleidungsteile ermöglicht eine strikte Trennung zwischen dem mechanischen Aufbau eines Geräteschrankes - also seines Gestells - und seiner hochfrequenzmäßigen Abschirmung. Das bedeutet, daß das Gestell ohne Rücksicht auf Abschirmmaßnahmen und damit kostengünstig konzipiert werden kann: das gleiche Gestell findet Einsatz bei geschirmten und nicht geschirmten Geräteschränken. Die Verkleidungsteile sind dabei nur noch untereinander elektrisch verbunden, alle bisher unumgänglichen elektrischen Verbindungen mit dem Gestell entfallen. Die Verkleidungsteile werden lediglich mechanisch am Gestell angeheftet, beispielsweise durch Anschrauben, Anhängen oder auch Anklemmen, von dem sie im übrigen elektrisch isoliert sind.

Nach einem weiteren vorteilhaften Merkmal der Erfindung sind die Verkleidungsteile mit abgewinkelten Randleisten versehen, welche die Kontaktflächen tragen. Diese Maßnahme verleiht den Verkleidungsteilen ausreichende Steifigkeit und erleichtert das Anbringen der Kontaktflächen, was auf verschiedene Weise geschehen kann.

Es erleichert insbesondere die Anordnung und die Abdichtung der als Türen dienenden Verbindungsteile, wenn die Randleisten an ringsumlaufenden, rechtwinkligen Abkantungen der Verkleidungsteile angesetzt sind.

Bei einer sehr vorteilhaften Ausführungsform der Erfindung sind die Randleisten aller Verkleidungsteile unter einem Winkel von ungefähr fünfundvierzig Grad ringsum nach innen abgebogen. Hier sind also alle Kontaktflächen gleich ausgebildet, und die Kontaktstreifen lassen sich sehr leicht anbringen. Die Randleisten können auch unter einem anderen spitzen Winkel nach innen abgebogen sein, sofern sich diese Winkel an den jeweils zusammenzufügenden Rändern zweier benachbarter Verkleidungsteile einander zu 90 Grad ergänzen.

Die Kontaktstreifen können auf den an den Randleisten vorgesehenen Kontaktflächen befestigt sein. Dies kann beispielsweise durch Aufklemmen oder auch Ankleben unter Verwendung von leitfähigem Kleber erfolgen.

Es ist auch möglich, die Kontaktstreifen am Gestell zu befestigen, was bei geeigneter Ausbildung der Kontaktstreifen beispielsweise durch Anklemmen geschehen kann.

Die Kontaktstreifen bestehen vorteilhaft aus Reihen von Federkontakten aus einem nichtoxydierenden metallischen Material oder aus gummielastischen leitfähigen Dichtungsstreifen. Wo es zweckmäßig erscheint - beispielsweise im Zusammenhang mit Abdichtungen von Türen - können als Kontaktstreifen auch elastische Metallgeflechte dienen, die gegebenenfalls einen Kern aus aufgeschäumtem, gummielastischem Kunststoff haben.

HF-Abschirmung und mechanische Abdichtung können auch getrennt ausgeführt werden, indem parallel neben den Kontaktstreifen zusätzliche gummielastische Dichtungsleisten zwischen den Kontaktflächen angeordnet werden.

Die Erfindung wird nachstehend anhand von zwei Ausführungsbeispielen unter Bezugnahme auf die beigefügten Zeichnungen näher beschrieben. Es zeigen:
- Fig. 1: die Verkleidungsteile eines Geräteschranks in einer ersten Ausführungsform, mit ringsumlaufenden, rechtwinkligen Abkantungen, in einer explosionsartigen Darstellung;
- Fig. 2: die Verkleidungsteile eines Geräteschranks in einer zweiten Ausführungsform, mit nach innen abgebogenen, ringsumlaufenden Randleisten, ebenfalls explosionsartig dargestellt;
- Fig. 3: einen Horizontalschnitt durch einen mit den Verkleidungsteilen gemäß Figur 1 ausgestatteten Geräteschrank;
- Fig. 4: einen Horizontalschnitt durch einen zweiten, mit den Verkleidungsteilen nach Figur 2 versehenen Geräteschrank;
- Fig. 5: eine erste Eckausbildung des in Figur 4 wiedergegebenen Geräteschrankes;
- Fig. 6: eine zweite Eckausbildung des in Figur 4 dargestellten Geräteschrankes.
- Fig. 7: eine dritte Alternative für die Ausbildung der Ecke des Geräteschranks von Figur 4.

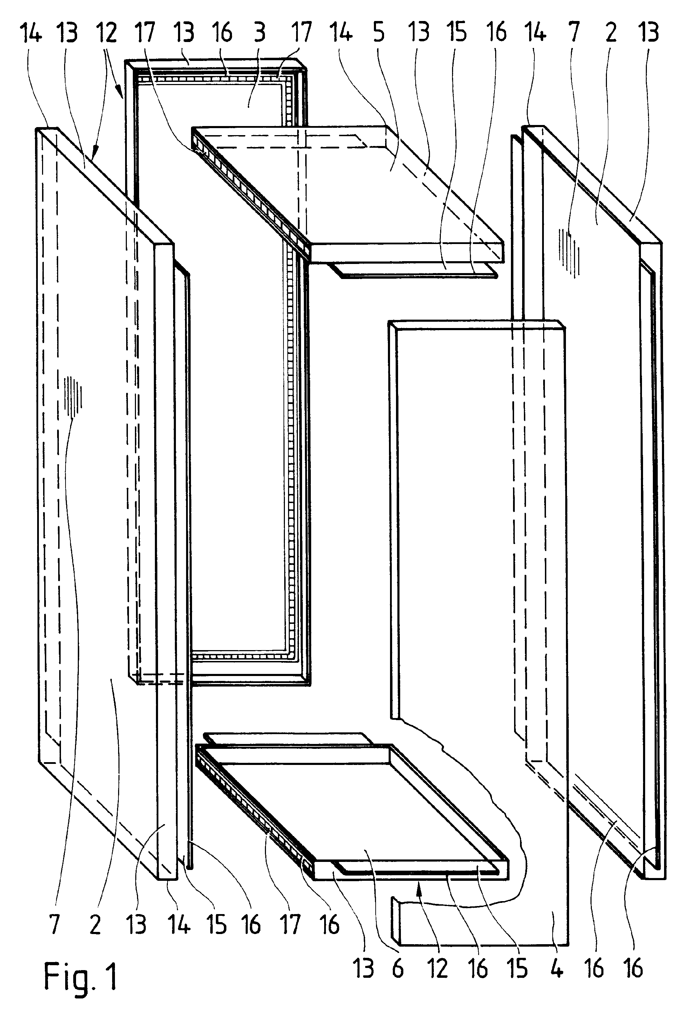

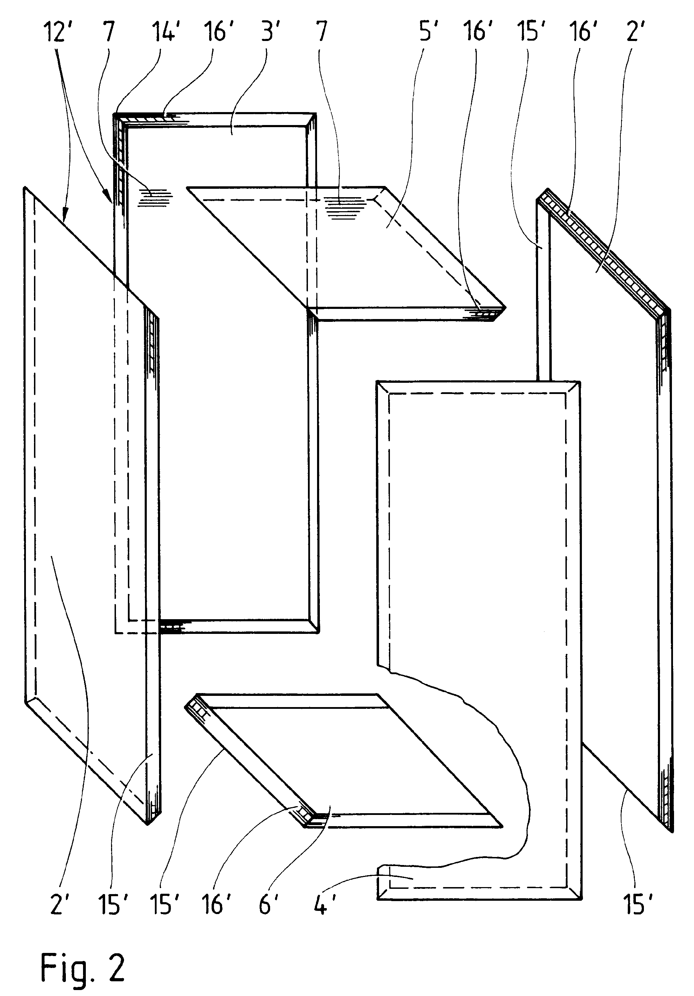

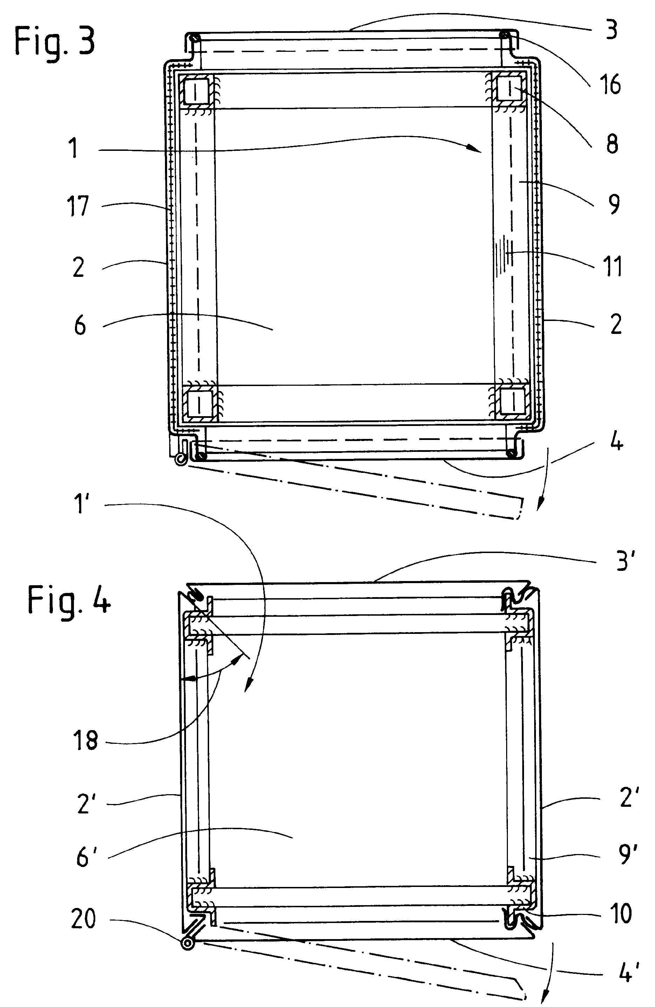

Der Geräteschrank zur Aufnahme von elektronischen und elektrischen Einschubgeräten, wie er in den Zeichnungen abgebildet ist, besteht im wesentlichen aus einem selbsttragenden, quaderförmigen Gestell 1 bzw. 1′ (Figuren 3 bis 5) zur Halterung der Einschübe sowie mehreren metallenen Verkleidungsteilen, nämlich (Figuren 1 und 2) Seitenwänden 2, 2′, Rückwand 3 bzw. 3′, Tür 4 bzw. 4′, Dach 5 bzw. 5′ sowie Boden 6 bzw. 6′. Diese Verkleidungsteile bestehen aus Stahlblech, und ihre Oberflächen sind durch eine oder mehrere Lackierungen 7 außen und innen gegen Korrosion entsprechend geschützt.

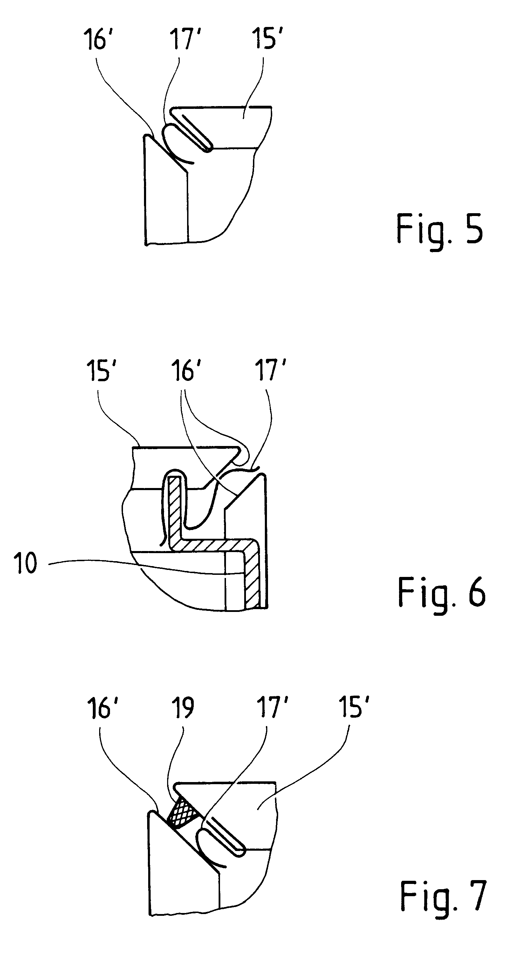

Das aus Rohren aus Stahl von quadratischem Querschnitt durch Schweißen zusammengesetzte Gestell 1 (Figur 3) besteht aus vier vertikalen Pfosten 8 und acht horizontalen Traversen 9; es ist mit (nicht dargestellten) Schienen, Teleskopen, Trägern und Holmen zur Befestigung der (nicht wiedergegebenen) Einschübe ausgestattet. Das in Figur 4 angedeutete Gestell 1′ ist mit Hilfe von im Querschnitt im wesentlichen U-förmigen Profilstäben 10 aus Stahl zusammengefügt und in entsprechender Weise ausgestattet. Auch die Gestelle 1, 1′ sind zum Schutz gegen äußere Einflüsse mit elektrisch nicht leitenden Überzügen 11, beispielsweise hergestellt durch Spritzlackieren oder Tauchen, versehen.

Die in Figur 1 dargestellten Verkleidungsteile, die beiden gleich ausgebildeten Seitenwände 2, die Rückwand 3, die Tür 4, das Dach 5 und der mit letzterem übereinstimmende Boden 6 sind als rechteckige, sehr niedere Wannen ausgebildet. Sie weisen an allen ihren Rändern 12 ringsumlaufende, rechtwinklige und gleich hohe Abkantungen 13 auf, die an den vier Ecken 14 zusammenstoßen und dort miteinander verbunden sind. An diese Abkantungen 13 sind bei den beiden Seitenwänden 2 sowie am Dach 5 und am Boden 6 abgewinkelte, gleich breite Randleisten 15 angesetzt, die rechtwinklig nach außen abstehen und jeweils nur bis nahe an die Ecken 14 herangeführt sind, damit das Dach 5 und der Boden 6 in die Seitenwand 2 eingeschoben werden können.

Entlang ihrer Ränder 12 weisen alle Verkleidungsteile 2, 3, 4, 5 und 6 elektrisch gut leitende Kontaktflächen 16 auf. Diese Kontaktflächen 16 liegen bei zusammengefügter Abschirmung und hierzu aneinander angestoßenen Verkleidungsteilen 2, 3, 4, 5 und 6 jeweils einander gegenüber.

Die miteinander korrespondierenden, metallisch blanken Kontaktflächen 16 werden bei den Randleisten 15 der Seiten 2, des Daches 3 und des Bodens 4 durch deren unlackierte Stoßkanten gebildet. Entsprechende, jedoch breitere Kontaktflächen 16 befinden sich weiterhin sowohl an den Innenseiten der Seitenteile 2 entlang deren Ränder 12 (wie in Figur 1 angedeutet) als auch an den seitlichen Abkantungen 13 des Daches 5 und des Bodens 6.

Zwischen den leitenden Kontaktflächen 16 gegenüberliegender Verkleidungsteile 2, 3, 4, 5 und 6 sind federelastische Kontaktstreifen 17 angeordnet (vergleiche Figur 3). Bei diesen Kontaktstreifen 17, die aus gut leitfähigem Material bestehen, handelt es sich um elastisch ausgebildete Metallgeflechte in Form von flexiblen Schnüren bzw. um Reihen bzw. Streifen von Federkontakten aus hochwertigem, korrosionsgeschützten, geeigneten Metall. Diese Kontaktstreifen 17 sind jeweils auf den Kontaktflächen 16 an den Randleisten 15 des einen der beiden nebeneinanderstehenden, einen gegenüber elektromagnetischen Wellen abzudichtenden Spalt bildenden Verkleidungsteile 2, 3, 4, 5 und 6 auf geeignete Weise elektrisch leitend befestigt.

Bei der in Figur 2 wiedergegebenen, alternativen Ausführungsform sind die zusammensetzbaren Verkleidungsteile ebenfalls wannenförmig ausgebildet, wobei die beiden Seitenwände 2′, die Rückwand 3′, die Tür 4′, das Dach 5′ und der Boden 6′ zur Bildung einer allseits geschlossenen, hochfrequenzdichten Abschirmung um das Gestell 1′ mit Randleisten 15′ versehen sind, die ringsumlaufend nach innen unter einem Winkel 18 von fünfundvierzig Winkelgraden abgebogen sind (Figur 4). Auch diese Randleisten 15′ sind an den Ecken 14′ der Verkleidungsteile 2′, 3′, 4′, 5′ und 6′ miteinander (beispielsweise durch Verschweißen) verbunden.

Entlang aller ihrer Ränder 12′ weisen die Verkleidungsteile 2′ bis 6′ ringsumlaufende, metallisch blanke und somit elektrisch gut leitende Kontaktflächen 16′ auf, die jeweils einander gegenüberliegen und so miteinander korrespondieren. Zwischen den streifenförmigen Kontaktflächen 16′ sind Kontaktstreifen 17′ aus einem federelastischen, elektrisch gut leitfähigen Material angeordnet. Solche Kontaktstreifen 17 tragen (vergleiche Figur 2) die Randleisten 15′ der beiden Seitenwände 2′, der Rückwand 3′ und der Tür 4′, während Dach 5′ und Boden 6′ lediglich mit Kontaktflächen 16′ versehen sind. Die zusammengefügten Verkleidungsteile 2′ bis 6′ bilden eine völlig geschlossene Abschirmung in Form eines quaderförmigen Kastens, welcher das Gestell 1 umgibt und die in ihm gehalterten Einschubgeräte im Sinne eines Faraday'schen Käfigs hervorragend gegenüber äußeren elektromagnetischen Wellen abschirmt bzw. das Austreten solcher, in den Einschubgeräten selbst erzeugten Störungen nahezu völlig dämpft, sofern nur alle vorhandenen Spalte zwischen den Verkleidungsteilen 2′ bis 6′ vollständig und lückenlos mittels Kontaktstreifen 17′ abgedichtet sind.

Die Befestigung der Kontaktstreifen 17′ kann (vergleiche Figur 5) durch Anklemmen an den Randleisten 15′ geschehen, wenn die Kontaktstreifen 17′ entsprechend - im Querschnitt etwa S-förmig - ausgebildet sind. Bei einer anderen Befestigungsart anders ausgebildeter Kontaktstreifen 17′ sind diese am Gestell 1 durch Anklemmen befestigt (siehe Figur 6).

In Figur 7 ist eine weitere Ausführung angedeutet, bei der parallel neben den metallenen Kontaktstreifen 17′ zusätzliche gummielastische Dichtungsleisten 19 für eine gute mechanische Abdichtung vorgesehen sind.

Die aus den zusammengesetzten Verkleidungsteilen 2, 2′ bis 6, 6′ bestehende, selbständige Abschirmung wird am Gestell 1, 1′ auf beliebige Weise, beispielsweise durch Anschrauben oder Anklemmen befestigt. Da dies sehr einfach vor sich gehen kann, lassen sich Geräteschränke wahlweise oder sogar nachträglich mit einer der beiden beschriebenen Abschirmungen versehen. Es versteht sich, daß einfache zusätzliche Maßnahmen für die Abschirmung z.B. der durch die Verkleidung herausgeführten Platten der Scharniergelenke 20 für die Türen 4, 4′ erforderlich sind, welche - da sie lediglich eines handwerklich geläufigen Aufwands bedürfen - hier nicht beschrieben werden.

### Zusammenstellung der Bezugsziffern

- 1, 1′: Gestell
- 2, 2′: Seitenwände
- 3, 3′: Rückwand
- 4, 4′: Tür
- 5, 5′: Dach
- 6, 6′: Boden
- 7: Lackierung
- 8: Pfosten
- 9: Traversen
- 10: Profilstäbe
- 11: Überzug
- 12, 12′: Ränder
- 13: Abkantungen
- 14, 14′: Ecken
- 15, 15′: Randleisten
- 16, 16′: Kontaktflächen
- 17, 17′: Kontaktstreifen
- 18: Winkel
- 19: Dichtungsleiste
- 20: Scharniergelenk

## Patentansprüche

1. Geräteschrank für elektronische und elektrische Einschubgeräte, mit einem selbsttragenden Gestell (1, 1′) zur Halterung der Einschubgeräte sowie mit metallenen Verkleidungsteilen, umfassend Seitenwände (2, 2′), Rückwand (3, 3′), Tür (4, 4′), Dach (5, 5′) und Boden (6, 6′), dadurch **gekennzeichnet**, daß zwecks Abschirmung gegenüber elektromagnetischen Wellen die Verkleidungsteile entlang ihrer Ränder (12, 12′) miteinander korrespondierende, elektrisch gut leitende Kontaktflächen (16, 16′) aufweisen, zwischen denen federelastische, aus elektrisch gut leitfähigem Material bestehende Kontaktstreifen (17, 17′) angeordnet sind.

2. Geräteschrank nach Anspruch 1, dadurch **gekennzeichnet**, daß die Verkleidungsteile (2, 2′; 3, 3′; 4, 4′; 5, 5′ und 6, 6′) mit abgewinkelten Randleisten (15, 15′) versehen sind, welche die Kontaktflächen (16, 16′) tragen.

3. Geräteschrank nach Anspruch 2, dadurch **gekennzeichnet**, daß die Randleisten (15) an ringsum laufenden, rechtwinkligen Abkantungen (13) der Verkleidungsteile (2, 3, 4, 5 und 6,) angesetzt sind.

4. Geräteschrank nach Anspruch 2, dadurch **gekennzeichnet**, daß die Randleisten (15′) unter einem Winkel (18) von ungefähr fünfundvierzig Grad ringsumlaufend nach innen umgebogen sind.

5. Geräteschrank nach einem der Ansprüche 2 bis 4, dadurch **gekennzeichnet**, daß die Kontaktstreifen (17, 17′) auf den an den Randleisten (15, 15′) vorgesehenen Kontaktflächen (16, 16′) befestigt sind.

6. Geräteschrank nach einem der Ansprüche 1 bis 4, dadurch **gekennzeichnet**, daß die Kontaktstreifen (17, 17′) am Gestell (1, 1′) befestigt sind.

7. Geräteschrank nach einem der Ansprüche 1 bis 6, dadurch **gekennzeichnet**, daß die Kontaktstreifen (17, 17′) aus Reihen von Federkontakten bestehen.

8. Geräteschrank nach einem der Ansprüche 1 bis 7, dadurch **gekennzeichnet**, daß als Kontaktstreifen (17, 17′) elastische Metallgeflechte dienen.

9. Geräteschrank nach einem der Ansprüche 4 bis 8, dadurch **gekennzeichnet**, daß parallel neben den Kontaktstreifen (17, 17′) zusätzlich gummielastische Dichtungsleisten (19) zwischen den Kontaktflächen (16, 16′) angeordnet sind.

## Claims

1. Appliance cabinet for electronic and electric plug-in devices, with a self-supporting frame (1, 1′) for supporting the plug-in devices as well as with metallic cladding parts, comprising side walls (2, 2′), a rear wall (3, 3′), a door (4, 4′), a lid (5. 5′) and a bottom (6, 6′), characterised in that, for the purpose of screening against electromagnetic waves, the cladding parts have mutually corresponding contact surfaces (16. 16′) along their edges (12, 12′) which are good electrical conductors, and elastically resilient contact strips (17, 17′) of a good electrical conduct or material arranged between the contact surfaces.

2. Appliance cabinet according to claim 1, characterised in that the cladding parts (2, 2′; 3, 3′; 4, 4′; 5, 5′ and 6, 6′) are provided with angled ledges (15, 15′) which carry the contact surfaces (16, 16′).

3. Appliance cabinet according to claim 2, characterised in that the ledges (15) are mounted on peripherally extending perpendicularly bent parts (13) of the cladding parts (2, 3, 4, 5 and 6).

4. Appliance cabinet according to claim 2, characterised in that the ledges (15′) are bent peripherally inwardly at an angle (18) of approximately 45 degrees.

5. Appliance cabinet according to any one of claims 2 to 4, characterised in that the contact strips (17, 17′) are secured to contact surfaces (16, 16′) provided at the ledges (15, 15′).

6. Appliance cabinet according to any one of claims 1 to 4, characterised in that the contact strips (17, 17′) are secured to the frame (1, 1′).

7. Appliance cabinet according to any one of claims 1 to 6, characterised in that the contact strips (17, 17′) consist of rows of spring contacts.

8. Appliance cabinet according to any one of claims 1 to 7, characterised in that resilient metallic braids serve as contact strips (17, 17′).

9. Appliance cabinet according to any one of claims 4 to 8, characterised in that additional rubber-elastic sealing bars (19) are arranged in parallel next to the contact strips (17, 17′) between the contact surfaces (16, 16′).

## Revendications

1. Armoire d'instruments pour des appareils électroniques et électriques embrochables, avec un bâti autoporteur (1, 1′) pour la fixation des appareils embrochables ainsi qu'avec des éléments de revêtement métalliques comprenant des parois latérales (2, 2′), une paroi arrière (3, 3′), une porte (4, 4′), un dessus (5, 5′) et un fond (6, 6′), **carac****térisée en ce** que pour le blindage contre des ondes électromagnétiques, les éléments de revêtement comportent, le long de leurs bords (12, 12′), des surfaces de contact (16, 16′) bonnes conductrices de courant électrique qui correspondent les unes avec les autres et entre lesquelles sont disposées des bandes de contact (17, 17′) à déformation élastique constituées d'un matériau bon conducteur d'électricité.

2. Armoire d'instruments selon la revendication 1, caractérisée en ce que les éléments de revêtement (2, 2′; 3, 3′; 4, 4′; 5, 5′ et 6, 6′) sont munis de rebords coudés (15, 15′) qui portent les surfaces de contact (16, 16′).

3. Armoire d'instruments selon la revendication 2, caractérisée en ce que les rebords (15) sont rapportés sur des chanfreins (13) rectangulaires des éléments de revêtement (2, 3, 4, 5 et 6) qui s'étendent tout autour.

4. Armoire d'instruments selon la revendication 2, caractérisée en ce que les rebords (15′) sont pliés tout autour sous un angle (18) d'environ 45°.

5. Armoire d'instruments selon l'une des revendications 2 à 4, caractérisée en ce que les bandes de contact (17, 17′) sont fixées sur les surfaces de contact (16, 16′) prévues sur les rebords (15, 15′).

6. Armoire d'instruments selon l'une des revendications 1 à 4 _{,}caractérisé en ce que les bandes de contact (17, 17′) sont fixées sur le bâti (1, 1′).

7. Armoire d'instruments selon l'une des revendications 1 à 6, caractérisée en ce que les bandes de contact (17, 17′) sont constituées par des rangées de contacts à ressort.

8. Armoire d'instruments selon l'une des revendications 1 à 7, caractérisée en ce que des treillis métalliques élastiques servent de bandes de contact (17, 17′).

9. Armoire d'instruments selon l'une des revendications 4 à 8, caractérisée en ce que, parallèlement à côté des bandes de contact (17, 17′), des baguettes d'étanchéité caoutchouteuses (19) supplémentaires sont disposées entre les surfaces de contact (16, 16′).
